# DEMANDE DE BREVET EUROPEEN

(11) **EP 2 249 168 A1**
(43) Date de publication de la demande: **10.11.2010**
(21) Numéro de dépôt: 10161380.0
(22) Date de dépôt: 28.04.2010
(51) Int. Cl.: G01R 22/06, G01D 4/00

(54) **Dispositif de gestion d'alimentation d'un compteur électrique**

(30) Priorité: 05.05.2009 FR 0952982
(71) Demandeur: Electricité Réseau Distribution France, 92085 Paris la Défense Cedex (FR)
(72) Inventeur: Boudouin, André, 38820, VIZILLE (FR)
(74) Mandataire: Cabinet Plasseraud

(57) **Abrégé**

L'invention concerne un dispositif de gestion d'alimentation (1) d'un compteur électrique comprenant des moyens d'alimentation électrique (PWR) et un module de commutation (SW) comportant une première entrée (I1) connectée aux moyens d'alimentation électrique, au moins une deuxième entrée (12) apte à être connectée à une source d'électricité externe au dispositif de gestion d'alimentation (1) et au moins une sortie (S) apte à être connectée au compteur électrique à réalimenter. Le module de commutation (SW) est apte à connecter la première entrée (I1) avec la sortie (S) dans un premier état de fonctionnement, après réception d'une requête en réalimentation par le dispositif de gestion d'alimentation. L'invention concerne aussi un système de mesure électrique comprenant un compteur électrique connecté à un dispositif tel que décrit ci-avant.

## Description

L'invention concerne le domaine des compteurs électriques, notamment les compteurs électriques pour équipements à haute tension.

Dans une installation alimentée par le réseau électrique, il est courant d'utiliser un dispositif, placé en amont de cette installation et en aval par rapport au réseau électrique, permettant d'effectuer des mesures relatives à la consommation d'électricité de l'installation. Un tel dispositif se nomme communément compteur électrique et permet différents types de mesures liées à la consommation électrique de l'installation.

Un compteur électrique peut par exemple servir à relever la consommation électrique d'une installation de façon globale, ou pendant une période de temps déterminée. Un compteur électrique, associé à un logiciel de facturation, peut également permettre de calculer le coût de la consommation électrique, en multipliant la consommation par un taux correspondant. Si des périodes différentes présentent des tarifs différents, un compteur électrique peut permettre de calculer le coût global correspondant à la somme des coûts des périodes intermédiaires.

Le relevé de ces différentes mesures s'est effectué pendant très longtemps par l'intermédiaire d'un agent se déplaçant sur le site de l'installation pour lire les index du compteur de conception électromécanique.

Depuis une vingtaine d'années le parc des compteurs s'est progressivement enrichi de diverses générations de compteurs électroniques, équipés de microprocesseurs, qui intègrent de nouvelles fonctionnalités dont, pour certains, celle permettant le télé-relevé, c'est-à-dire le relevé à distance des mesures, ou télémesure, afin d'éviter le déplacement des agents qui entraine des frais. Ce type de télémesure est particulièrement adapté au relevé des compteurs électriques ou électroniques situés dans des régions rurales ou peu accessibles.

Certains compteurs électroniques spécifiques sont adaptés à certains types d'application. Par exemple, pour des installations électriques alimentées en haute tension, sous 15 ou 20KV, les compteurs nécessitent l'emploi de transformateurs de courant de mesure (dits « TC ») placés au secondaire (en Basse Tension) du transformateur de puissance Haute Tension/Basse Tension (dit « HTA/BT ») de l'installation, ou au contraire au primaire (en Haute Tension) notamment dans le cas d'installations de forte puissance. Les références de tension étant prises au secondaire (en Basse Tension), ou au primaire (en Haute Tension) dans ce dernier cas des Transformateurs de Tension de mesure (dits « TT »), sont intercalés pour réduire le niveau des tensions appliquées au compteur.

Un exemple de compteur électronique régulièrement utilisé pour des installations à haute tension est le compteur « ICE » (pour Interface Client Emeraude), spécifiquement adapté à une utilisation saisonnière. La puissance souscrite par de telles installations dépasse souvent les 250 kW, ce qui peut obliger à effectuer un suivi journalier de ces compteurs. (télé-relevé des index et/ou des puissances moyennes sous la forme de courbes de charge)

Certaines installations électriques comme les remontées mécaniques, les télésièges ou les matériels d'arrosage agricole ne fonctionnent qu'à certaines périodes de l'année et/ou de manière épisodique. Leurs propriétaires procèdent souvent à la mise hors tension des installations en dehors des périodes d'utilisation pour des raisons de sécurité (par exemple pour les sites isolés sans surveillance) ou afin de réduire leur consommation électrique.

Pour un grand nombre d'installations à Haute Tension de forte puissance, des Transformateurs de Tension de mesure sont généralement placés en amont du disjoncteur HTA et de ce fait les compteurs restent donc fonctionnels. Dans certains cas par contre, le point de coupure Haute Tension peut se trouver en amont des Transformateurs de Tension de mesure et ceux-ci sont alors mis hors tension, privant le compteur électronique de son énergie et rendant de ce fait impossible le télé-relevé.

Dans une installation à Haute Tension ne dépassant pas 2000KVA et équipée d'un seul transformateur de puissance HTA/BT, le compteur est généralement alimenté par le secondaire Basse Tension de ce transformateur. En cas de mise hors tension du transformateur de puissance, ce même compteur électronique n'est plus alimenté, interdisant tout relevé ou télé-relevé.

Ceci a pour conséquence de reporter la consommation d'électricité non relevée sur la facture correspondant au redémarrage du compteur électrique, qui peut se produire un certain temps après l'extinction du compteur électrique. Par exemple, dans le cas d'un télésiège dont le compteur est éteint à la fin de la saison hivernale, vers le mois d'avril, la consommation des dernières semaines de la saison n'apparaitra que sur les factures du début de la saison suivante, vers le mois de décembre, ce qui entraîne une perte de trésorerie importante pour le fournisseur d'électricité.

Si le fournisseur d'électricité souhaite effectuer une télémesure d'un compteur électrique hors de sa période d'utilisation, il est bien sûr possible d'envoyer un technicien sur les lieux de l'installation afin de remettre temporairement sous tension l'installation Haute Tension (sous réserve de l'accord écrit du responsable de l'installation) et permettre ainsi, le compteur étant réalimenté, un relevé manuel ou le télé-relevé. Ceci réduit cependant l'intérêt de la télémesure par les coûts entrainés par le déplacement d'un technicien, en particulier dans des zones rurales et difficiles d'accès.

La présente invention vient améliorer la situation. Elle permet, entre autres, d'effectuer la télémesure d'un compteur électronique éteint, par exemple hors de sa période d'utilisation.

Elle propose à cet effet un dispositif de gestion d'alimentation d'un compteur comprenant des moyens d'alimentation électrique et un module de commutation comportant une première entrée connectée aux moyens d'alimentation électrique, au moins une deuxième entrée apte à être connectée à une source d'électricité externe au dispositif de gestion d'alimentation et au moins une sortie apte à être connectée au compteur électrique à réalimenter, le module de commutation étant apte à connecter la première entrée avec la sortie dans un premier état de fonctionnement, après réception d'une requête en réalimentation par le dispositif de gestion d'alimentation.

Avantageusement, le module de commutation est apte à connecter la au moins deuxième entrée avec la au moins une sortie dans un deuxième état de fonctionnement, de sorte à pouvoir basculer dans le premier état de fonctionnement si la tension d'entrée de la au moins deuxième entrée est inférieure à une valeur de tension seuil et à pouvoir basculer dans le deuxième état de fonctionnement si la tension d'entrée de la au moins deuxième entrée est supérieure ou égale à une valeur de tension seuil. Ceci permet d'assurer le retour à un fonctionnement normal lorsque l'alimentation par le réseau électrique est de nouveau activée.

Plus particulièrement, le module de commutation comprend un premier sous-module de commutation présentant une première entrée, au moins une deuxième entrée connectée à la au moins une deuxième entrée du module de commutation, et au moins une sortie connectée à la au moins une deuxième sortie du module de commutation, le moyen de commutation comprenant en outre un deuxième sous-module de commutation présentant une entrée, connectée à l'entrée du module de commutation, et une sortie, connectée à la première entrée du premier sous-module de commutation. Le premier-module de commutation connecte sa sortie avec sa première entrée si la tension d'entrée de sa au moins deuxième entrée est inférieure à la valeur de tension seuil, le premier-module de commutation connecte sa sortie avec sa au moins deuxième entrée si la tension d'entrée de sa au moins deuxième entrée est supérieure ou égale à la valeur de tension seuil, et le deuxième sous-module de commutation connecte son entrée avec sa sortie après réception d'une requête en réalimentation.

Avantageusement, le dispositif de gestion d'alimentation comprend en outre des moyens d'activation connectés au module de commutation, aptes à recevoir une requête en gestion d'alimentation et à déclencher le basculement dudit module de commutation dans son premier état de fonctionnement en réponse à la requête en réalimentation.

Dans un mode préféré, les moyens d'activation comportent au moins un module d'activation téléphonique apte à recevoir la requête en réalimentation sous forme téléphonique. Cela permet l'activation à distance du compteur.

De préférence, le module d'activation téléphonique comporte un module d'activation téléphonique sans fil apte à recevoir la requête en réalimentation sous forme téléphonique par voie hertzienne. Il est ainsi possible d'activer à distance le compteur électrique, dans des zones difficiles d'accès, potentiellement non reliées au réseau téléphonique filaire, mais couvertes par le réseau téléphonique sans fil.

Le dispositif de gestion d'alimentation comprend avantageusement un module d'horloge connecté au module d'activation téléphonique sans fil et apte à activer ledit module d'activation téléphonique sans fil durant au moins une période de temps et à désactiver lesdits moyens d'activation en dehors de ladite au moins une période de temps.

Dans un mode de réalisation préféré, le module d'horloge est connecté aux moyens d'alimentation électrique et est apte à connecter le module d'activation téléphonique sans fil aux moyens d'alimentation électrique durant ladite au moins une période de temps, et à isoler le module d'activation téléphonique sans fil des moyens d'alimentation électrique en dehors de ladite au moins une période de temps.

Dans un autre mode de réalisation préféré, les moyens d'activation comportent un module d'activation magnétique apte à recevoir la requête en réalimentation sous forme d'un signal magnétique. Ce module permet de déclencher la télé-relève au moyen d'un terminal de saisie portable.

Préférentiellement, les moyens d'activation comportent un module d'activation manuelle apte à recevoir la requête en réalimentation sous forme d'un signal manuel. Ce module permet à un opérateur (non technicien) ou au client lui-même de déclencher la réalimentation du compteur afin de permettre un relevé sur site ou un télé-relevé, sans remise sous tension de l'installation Haute Tension, en cas de problème avec les autres modules d'activation.

De préférence, les moyens d'alimentation comportent un module de conversion photoélectrique apte à convertir de l'énergie lumineuse en énergie électrique fournie au moins partiellement à la première entrée du moyen de commutation. Ceci permet d'assurer l'autonomie des moyens d'alimentation locale et de réduire la maintenance nécessaire à la recharge de batteries sur place.

De préférence, les moyens d'alimentation comportent un module de stockage électrique apte à stocker de l'énergie électrique destinée à être fournie au moins partiellement à la première entrée du moyen de commutation. Avec un tel module, l'excès d'énergie solaire non utilisée directement peut être stocké électriquement, pour une utilisation ultérieure.

Dans un autre mode de réalisation préféré, le moyen de commutation comporte une deuxième entrée, une troisième entrée, une quatrième entrée et une cinquième entrée aptes à recevoir respectivement un premier signal de phase, un deuxième signal de phase, un troisième signal de phase et un signal neutre provenant d'une source d'électricité triphasée, et dans lequel le moyen de commutation comporte une première sortie, une deuxième sortie, une troisième sortie et une quatrième sortie aptes à être connectées respectivement à la première entrée de phase, la deuxième entrée de phase, la troisième entrée de phase et l'entrée neutre d'un compteur électrique triphasé, **caractérisé en ce que**, dans ledit premier état de fonctionnement, la première entrée du module de commutation est connectée à la première sortie du module de commutation, et en ce que, dans le deuxième état de fonctionnement, les deuxième, troisième, quatrième et cinquième entrées du module de commutation sont connectées respectivement aux première, deuxième, troisième et quatrième sorties du module de commutation. Un tel moyen de commutation permet de gérer l'alimentation locale d'un compteur électrique triphasé.

La présente invention concerne aussi un système de mesure électrique comprenant un compteur électrique, comportant au moins une entrée apte à recevoir un signal électrique, et un dispositif de gestion d'alimentation selon l'une des revendications précédentes, la au moins une sortie du module de commutation du dispositif de gestion d'alimentation étant connectée à la au moins une entrée du compteur électrique.

D'autres caractéristiques et avantages de l'invention apparaîtront à l'examen de la description détaillée ci-après, et des dessins annexés sur lesquels :
- la figure 1 illustre un premier mode de réalisation du dispositif de gestion d'alimentation selon l'invention ;
- les figures 2A-2C représentent schématiquement les différentes positions possibles prises par les commutateurs internes au module de commutation du premier mode de réalisation du dispositif de gestion d'alimentation selon l'invention ;
- la figure 3 illustre un deuxième mode de réalisation du dispositif de gestion d'alimentation selon l'invention ;
- les figures 4A-4C représentent schématiquement les différentes positions possibles prises par les commutateurs internes au module de commutation du deuxième mode de réalisation du dispositif de gestion d'alimentation selon l'invention ;
- la figure 5 illustre un exemple de réalisation du premier sous-module de commutation interne au module de commutation selon le deuxième mode de réalisation du dispositif de gestion d'alimentation de l'invention ;
- la figure 6 illustre un exemple de réalisation des moyens d'activations et d'un deuxième sous-module de commutation interne au module de commutation selon l'un quelconque des modes de réalisation du dispositif de gestion d'alimentation de l'invention ; et
- les figures 7A et 7B représentent des chronogrammes illustrant l'avantage apporté par l'utilisation d'une temporisation dans un mode préféré de l'invention.

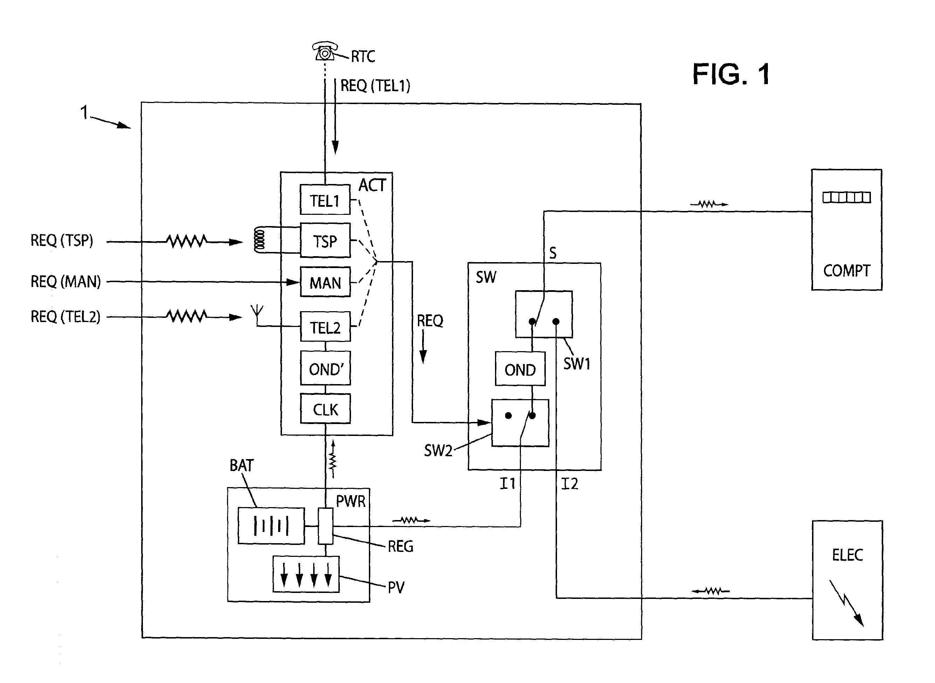

On se réfère tout d'abord à la **figure 1** illustrant un premier mode de réalisation d'un dispositif de gestion d'alimentation 1 selon l'invention.

Le dispositif de gestion d'alimentation 1 est représenté comme étant inséré en amont du compteur électrique COMPT à réalimenter, lequel est par exemple un compteur électronique, par rapport à la source d'électricité ELEC, par exemple le réseau électrique, alimentant habituellement ce compteur COMPT. Le dispositif 1 comporte des moyens d'alimentation électrique PWR ainsi qu'un module de commutation SW, les moyens d'alimentation PWR étant connectés à une première entrée I1 du module de commutation SW.

Le module de commutation SW est apte à être connecté, d'une part, au compteur électrique COMPT à gérer grâce à une sortie S et, d'autre part, au réseau électrique ELEC grâce à une deuxième entrée 12. Ce module SW permet la connexion électrique du compteur électrique COMPT avec soit la source d'électricité ELEC, soit les moyens d'alimentation électrique PWR.

Dans l'exemple présent, le commutateur SW comporte un premier sous-module de commutation SW1 présentant deux entrées et une sortie. La sortie du sous-module SW1 est directement connectée à la sortie S du commutateur SW, et une de ses entrées est directement connectée à l'entrée 12 du commutateur SW. L'autre entrée du sous-module SW1 est connectée directement à l'une des sorties d'un deuxième sous-module de commutation SW2, qui lui présente deux sorties et une entrée. L'entrée de ce sous-module SW2 est connectée directement à la première entrée I1 du module de commutation SW et l'autre sortie de ce sous-module n'est pas nécessairement connectée à un quelconque élément.

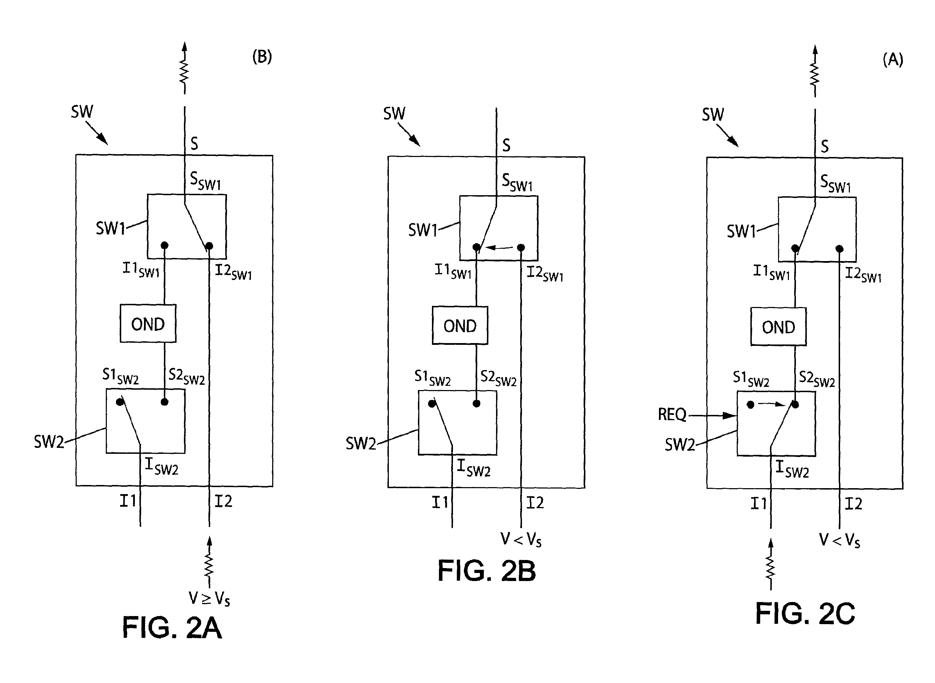

Dans un état B de fonctionnement normal, illustré à la **figure 2A**, dans lequel le compteur électrique COMPT est alimenté par la source électrique ELEC, l'entrée I2_{SW1} du premier sous-module de commutation SW1 est connectée à la sortie S_{SW1}, ce qui implique alors que l'entrée 12 du module de commutation est reliée à la sortie S de ce module de commutation. Ainsi, le compteur électrique COMPT est connecté au réseau électrique ELEC et peut être alimenté par celui-ci, peu importe la position du deuxième sous-module de commutation SW2.

Si l'alimentation par le réseau électrique s'interrompt, c'est-à-dire quand la tension électrique détectée à l'entrée I2_{SW1} du premier sous-module de commutation SW1 passe en dessous d'une certaine valeur de seuil Vs, le sous-module SW1 détecte cette baisse de tension et va commuter dans un état d'attente illustré à la **figure 2B**. Dans cet état d'attente, la sortie S et les entrées I1 et 12 du module de commutation SW ne sont pas connectées entre elles.

Si dans cet état d'attente, le module de commutation SW reçoit une requête REQ en réalimentation du dispositif, le module de commutation SW bascule alors dans un état A d'alimentation locale du compteur, comme illustré à la **figure 2C**. Pour ce faire, le deuxième sous-module de commutation SW2 bascule alors dans une position où son entrée I_{SW2} est connectée avec sa sortie S2_{SW2}, qui est elle-même connectée avec l'entrée I1_{SW1} du premier sous-module de commutation SW1, donc avec la sortie S du module SW. Ainsi, dans un tel état de fonctionnement, la première sortie I1 et la sortie S du module de commutation SW sont connectées, ce qui permet l'alimentation électrique du compteur COMPT par les moyens d'alimentation PWR connectés à cette entrée I1.

Une fois dans cet état A d'alimentation locale de la figure 2C, si l'alimentation par le réseau électrique traditionnel est redémarrée, le sous-module SW1 détecte qu'une tension dépassant la valeur de seuil Vs se présente sur son entrée I2_{SW1} et interprète cette hausse de tension comme un redémarrage de l'alimentation électrique par le réseau. Le sous-module SW1 va alors rebasculer dans l'état B de fonctionnement normal de la figure 2A.

La requête en réalimentation peut être reçue de plusieurs façons différentes. Pour ce faire, le dispositif 1 peut comprendre des moyens d'activation ACT, comme illustré à la figure 1, émettant une requête en réalimentation REQ à destination du module de commutation SW. Ces moyens d'activation ACT comportent un ou plusieurs modules d'activation permettant de détecter une requête en réalimentation provenant d'un opérateur, notamment quand celui-ci désire effectuer un relevé ou un télé-relevé nécessitant la réalimentation du compteur électrique COMPT.

Un premier exemple de module d'activation consiste en un module d'activation manuelle MAN, comme un bouton pressoir par exemple. La pression d'un tel bouton pressoir, schématisé par REQ(MAN) sur la figure 1, indiquera qu'un opérateur désire réalimenter le compteur électrique et une requête REQ sera alors émise vers le module SW afin de permettre son basculement dans l'état A d'alimentation locale illustré à la figure 2C.

Un deuxième exemple de module d'activation consiste en un module d'activation magnétique TSP (pour Terminal Saisie Portable), capable de détecter la proximité d'un champ magnétique prédéfini, par exemple un flux avec une fréquence de 50 KHz. L'apparition d'un tel champ magnétique, schématisé par REQ(TSP) sur la figure 1, indiquera qu'un opérateur désire réalimenter le compteur électrique et une requête REQ sera alors émise vers le module SW afin de permettre son basculement dans l'état A d'alimentation locale illustré à la figure 2C.

Ces deux premiers exemples de module d'activation nécessitent une certaine proximité de l'opérateur avec le dispositif 1, ce qui est contraignant quand ce dispositif 1 se trouve dans une zone d'accès limité. Afin de contourner ce problème, les moyens d'activation ACT peuvent comporter un module d'activation téléphonique, générant une requête en réalimentation REQ sur réception d'un signal téléphonique.

Un premier exemple de module d'activation téléphonique consiste en un module d'activation téléphonique filaire TEL1, relié au réseau téléphonique filaire public RTC par exemple. La réception d'un signal téléphonique, comme par exemple un appel REQ(TEL1), indiquera alors qu'un opérateur distant désire réalimenter le compteur électrique, ce qui entraînera l'émission d'une requête REQ vers le module SW afin de permettre son basculement dans l'état d'alimentation locale à la figure 2C. Un tel module d'activation doit cependant être connecté au réseau téléphonique public RTC, ce qui limite le positionnement du dispositif 1 aux endroits couverts par ce réseau filaire.

Pour contourner ce problème, un deuxième exemple de module d'activation téléphonique consiste en un module d'activation téléphonique sans fil TEL2, muni par exemple d'une antenne capable de recevoir un signal téléphonique sans fil REQ(TEL2), par voie hertzienne, par exemple une antenne GSM. Ce module d'activation TEL2 générera une requête REQ à destination du module SW sur réception d'un signal téléphonique sans fil, afin de provoquer le basculement du commutateur SW dans l'état A de fonctionnement illustré à la figure 2C. Avec un tel module d'activation téléphonique sans fil, il devient possible de commander la réalimentation de compteurs électriques situés dans des endroits difficiles d'accès, sous réserve qu'ils soient couverts par un réseau sans fil.

Comme déjà indiqué, la réalimentation du compteur électrique se fait grâce aux moyens d'alimentation électrique PWR. De tels moyens peuvent comporter d'une part un module de stockage électrique BAT, comme une batterie 12 volts au plomb par exemple. Une telle batterie fournira alors l'électricité nécessaire au compteur électrique, avec une autonomie limitée à sa charge. Ce module de stockage BAT peut être remplacé à des instants relativement espacés dans le temps, par exemple à la fin de chaque saison d'utilisation du compteur COMPT, afin que le dispositif de réalimentation 1 soit alimenté électriquement durant la période d'inactivité du compteur COMPT.

Afin de contourner le problème lié à l'autonomie d'une telle batterie, les moyens d'alimentation PWR peuvent comporter un module de conversion photoélectrique PV, par exemple à base de cellules photovoltaïques, permettant l'alimentation du compteur par conversion de l'énergie solaire, ou fournissant de l'énergie à une batterie de stockage BAT afin que celle-ci soit utilisée ultérieurement dans le même effet. Avec un tel module PV, la maintenance du dispositif 1 peut être réduite puisqu'il n'est plus nécessaire de se déplacer pour recharger les moyens d'alimentation PWR si ceux-ci ne comportent que des moyens de stockage électrique traditionnels.

Un dimensionnement adéquat du nombre de cellules photovoltaïques employées dans ce module PV permet de fournir suffisamment d'électricité pour alimenter le compteur pendant une certaine durée. La puissance délivrée par ce module PV peut être définie en fonction des modules à alimenter localement. Ainsi, si les moyens d'activation ACT ne comprennent qu'un module d'activation téléphonique filaire TEL1, un certain niveau de puissance sera suffisant, de l'ordre de 20 Watts, ce qui correspond à un certain nombre de cellules photovoltaïques, en fonction du rendement de celles-ci. Par contre, si les moyens d'activation ACT ne comprennent qu'un module d'activation téléphonique sans fil TEL2, un niveau de puissance plus élevé sera nécessaire, de l'ordre de 50 W, ce qui correspond à un plus grand nombre de cellules photovoltaïques, à rendement égal.

En plus de servir à réalimenter le compteur COMPT, les moyens d'alimentation PWR peuvent servir à alimenter d'autres éléments internes au dispositif 1. Par exemple, si les moyens d'activation ACT comportent un module téléphonique sans fil TEL2, un tel module sans fil peut nécessiter d'être alimenté électriquement pour pouvoir recevoir un signal téléphonique sans fil, ce qui peut être réalisé grâce aux moyens d'alimentation PWR.

Cependant, dans un tel cas, l'alimentation permanente du module d'activation téléphonique sans fil peut consommer beaucoup d'énergie, voire épuiser toute l'énergie électrique stockée ou générée par les moyens d'alimentation PWR, ce qui empêcherait alors toute alimentation du compteur électrique COMPT. Afin de résoudre cet inconvénient, il est possible d'ajouter un module d'horloge CLK entre les moyens d'alimentation PWR et les moyens d'activation TEL2.

Le module d'horloge CLK ne va autoriser l'alimentation du module d'activation téléphonique sans fil que pendant une ou plusieurs périodes prédéfinies, limitant ainsi la consommation électrique du module. Par exemple, il est possible de définir une période d'une heure dans la journée et une période d'une heure dans la nuit, pendant lesquelles le module d'horloge CLK autorise l'alimentation du module d'activation téléphonique sans fil, ce qui coupe cette alimentation pendant les vingt-deux autres heures restantes. En dehors de ces périodes prédéfinies, le module d'activation connecté au module d'horloge CLK est désactivé et ne transmettra pas une éventuelle requête en alimentation du compteur au sous-module de commutation SW2.

Ce module d'horloge CLK peut comprendre, par exemple, 2 interrupteurs en parallèle, situés entre les moyens d'alimentation PWR et le module d'activation TEL2, se fermant respectivement pendant une heure de la nuit et une heure du jour et restant ouvert le reste du temps. Un tel module d'horloge peut être programmé pour tenir du changement d'horaire intervenant habituellement le dernier dimanche des mois de mars et octobre. Il peut être alimenté par une pile au lithium, ce qui lui donne une autonomie importante.

Les moyens d'alimentation électrique PWR comprennent avantageusement un module régulateur REG connecté au module d'alimentation photovoltaïque PV et/ou au module de stockage électrique BAT. Un tel module régulateur REG reçoit de l'électricité du module d'alimentation photovoltaïque PV et/ou du module de stockage électrique BAT2, et régule celle-ci de façon à fournir en sortie un courant continu d'une certaine valeur de tension (par exemple 12 Volts) destiné au module de commutation SW et/ou aux moyens d'activation ACT.

Il est cependant possible que certains éléments alimentés par les moyens d'alimentation PWR ne soient pas compatibles avec une tension continue telle que fournie par le régulateur REG. Dans un tel cas, un ondulateur transformant le courant continu d'une certaine valeur tension (12 Volts, par exemple) en un courant alternatif d'une autre valeur de tension (230 Volts, par exemple) peut être employé.

Tel peut être le cas en sortie du module d'horloge CLK, où un ondulateur OND' peut convertir la tension continue reçue de ce module en une tension alternative de 230 Volts destinée à alimenter le module d'activation sans fil TEL2. Tel est aussi le cas à la sortie S2_{SW2} du second sous-module de commutation SW2, où un ondulateur OND permet de convertir le courant continu reçu des moyens d'alimentation PWR en courant alternatif pour le compteur COMPT à alimenter localement.

Comme indiqué précédemment, sur réception d'une requête d'un opérateur extérieur, les moyens d'activation ACT vont générer une requête en basculement du sous-module de commutation SW2. Les moyens d'activation ACT peuvent être capables de recevoir une requête en activation ou en désactivation, et ce selon plusieurs modes de fonctionnement.

Dans un premier mode de fonctionnement, on peut considérer que la simple réception d'un signal quelconque, que ce soit un signal téléphonique reçu par l'un des modules TEL1 ou TEL2, un champ magnétique spécifique détecté par le module TSP ou une impulsion reçue par le module MAN, fait office de requête en activation/désactivation et est indicative d'un basculement du sous-module de commutation SW2 dans une position différente de celle dans laquelle il se trouve au moment où la requête est reçue. Dans ce premier mode, les moyens d'activation ACT commande alors au sous-module de commutation SW2 de changer de position, sans tenir compte de sa position initiale et sans tenir compte du contenu du signal reçu.

Dans un deuxième mode de fonctionnement, la requête reçue peut être analysée par les moyens d'activation ACT, afin de déterminer si le signal reçu constitue une réelle requête en activation/désactivation. Dans ce deuxième mode, avec une requête en activation/désactivation par signal téléphonique par exemple, cette requête téléphonique doit alors présenter certaines particularités, par exemple dans son contenu, son intensité ou sa forme, permettant de distinguer cette requête d'un autre signal. Un tel mode permet par exemple d'éviter l'activation/désactivation accidentelle du compteur électrique sur réception d'un appel téléphonique erroné.

Dans une variante du deuxième mode de fonctionnement, l'analyse du signal reçu peut être plus poussée et permettre de déterminer si ce signal correspond à une requête en activation ou à une requête en désactivation. Dans ce mode, les moyens d'activation ACT sont aptes à connaître la position du sous-module de commutation SW2, qui correspond soit à un état d'alimentation locale, soit à un état d'extinction du compteur électrique COMPT. En fonction de cet état et du type de requête reçue, les moyens d'activation ACT commanderont ou non le basculement du sous-module de commutation SW2 dans une autre position correspondant à la requête reçue.

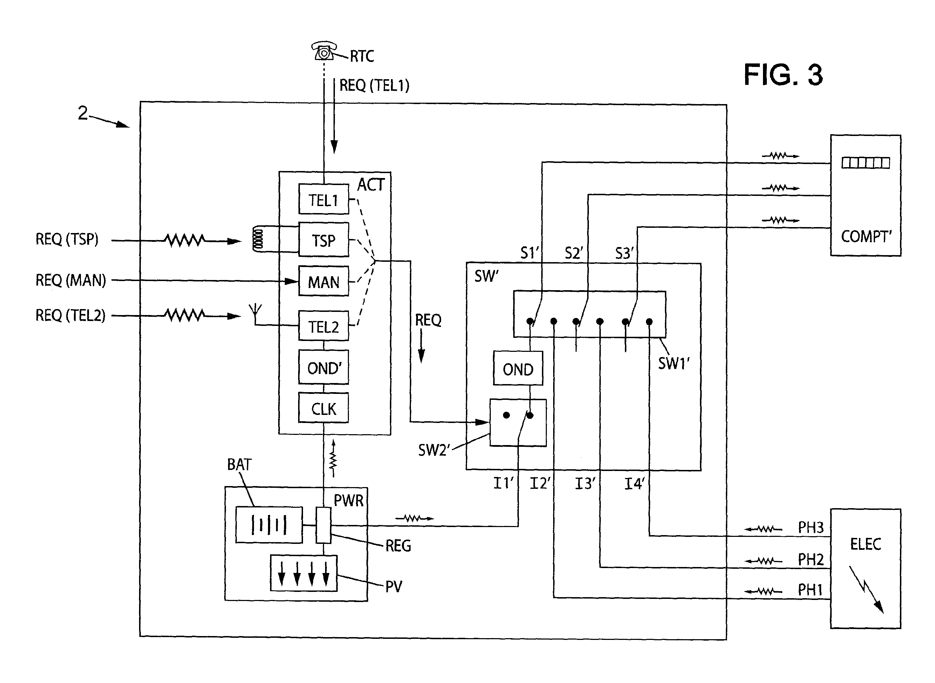

La **figure 3** illustre un deuxième mode de réalisation d'un dispositif de gestion d'alimentation 2 selon l'invention, plus spécialement adapté à des compteurs triphasés.

Ce dispositif 2 comporte des moyens d'alimentation PWR et des moyens d'activation ACT similaires à ceux dispositif 1. Il se distingue cependant par son module de commutation SW', spécialement adapté pour un système triphasé, car comportant quatre entrées I1'-I4' et trois sorties S1'-S3'. L'entrée I1' est connectée aux moyens d'alimentation PWR et les trois entrées I2'-I4' sont connectées respectivement aux trois phases PH1-PH3 du réseau électrique ELEC. Les trois sorties S1'-S3' sont connectées respectivement aux trois phases d'un compteur électrique triphasé COMPT'.

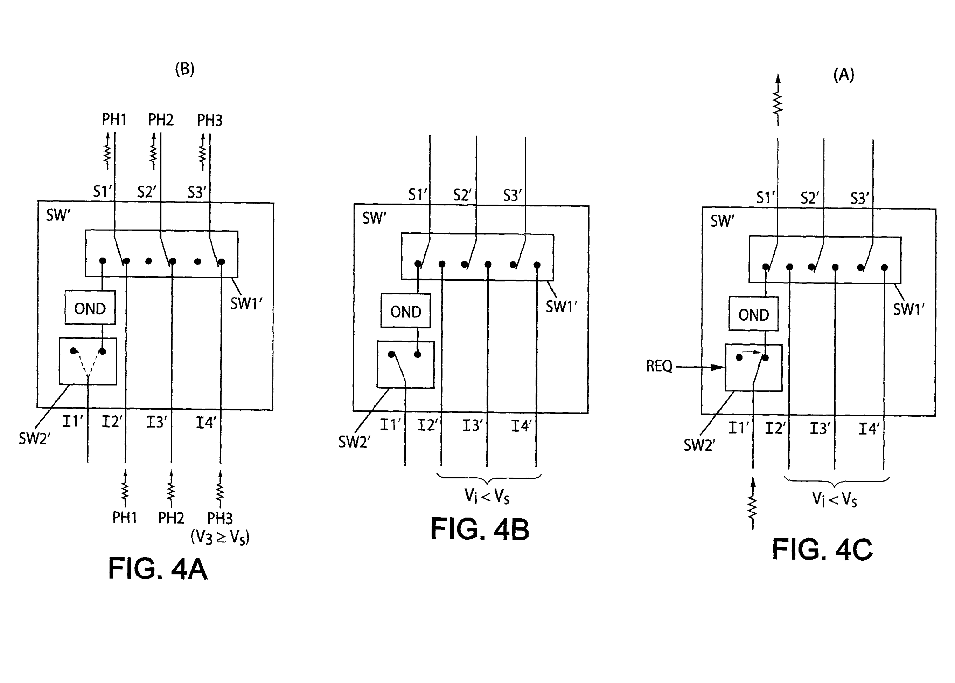

Les **figures 4A-4C** illustrent en détail ce module de commutation SW', dans trois états de fonctionnement différents, de façon similaires aux figures 2A-2C.

Dans un état B de fonctionnement normal, illustré à la figure 4A, les trois entrées I2'-I4' sont connectées aux trois sorties S1'-S3', de sorte que les trois phases PH1-PH3 du réseau électrique triphasé alimentent le compteur triphasé. Tant qu'au moins une des phases PH1-PH3 présente une valeur de tension supérieure à une valeur seuil Vs (ici, la tension V3 de la phase PH3, à titre purement illustratif), l'électronique du compteur reste fonctionnelle.

Lorsque le sous-module de commutation SW1' détecte que l'alimentation par le réseau électrique s'interrompt, par exemple quand la tension électrique Vi détectée à chacune des entrées I2'-I4' du sous-module SW1' passe en dessous d'une certaine valeur de seuil Vs, le sous-module SW1 détecte cette chute de tension et va commuter dans un état d'attente illustré à la figure 4B. Dans cet état d'attente, les sorties S1'-S3' et les entrées I1'-I4' du module de commutation SW ne sont pas connectées entre elles.

Si dans cet état d'attente, le module de commutation SW' reçoit une requête REQ en réalimentation du dispositif, le module de commutation SW' bascule alors dans un état A d'alimentation locale du compteur triphasé illustré à la figure 2C. Pour ce faire, le deuxième sous-module de commutation SW2 bascule alors dans une position où son entrée est connectée avec sa sortie qui est elle-même connectée avec une des entrées du premier sous-module SW1', donc avec la sortie S1' du module de commutation SW. Ainsi, dans un tel état de fonctionnement, la première sortie I1' et la sortie S1' du module de commutation SW' sont connectées, ce qui permet l'alimentation électrique du compteur triphasé' par les moyens d'alimentation PWR connectés à cette entrée I1'.

Une fois dans cet état d'alimentation locale de la figure 4C, si l'alimentation par le réseau électrique traditionnel est redémarrée, le sous-module SW1' détecte qu'une tension Vi dépassant la valeur de seuil Vs se présente sur au moins une de ses trois entrées connectées aux entrées I2'-I4' et interprète cette hausse de tension comme un redémarrage de l'alimentation électrique par le réseau triphasé. Le sous-module SW1' va alors rebasculer dans l'état B de fonctionnement normal de la figure 4A.

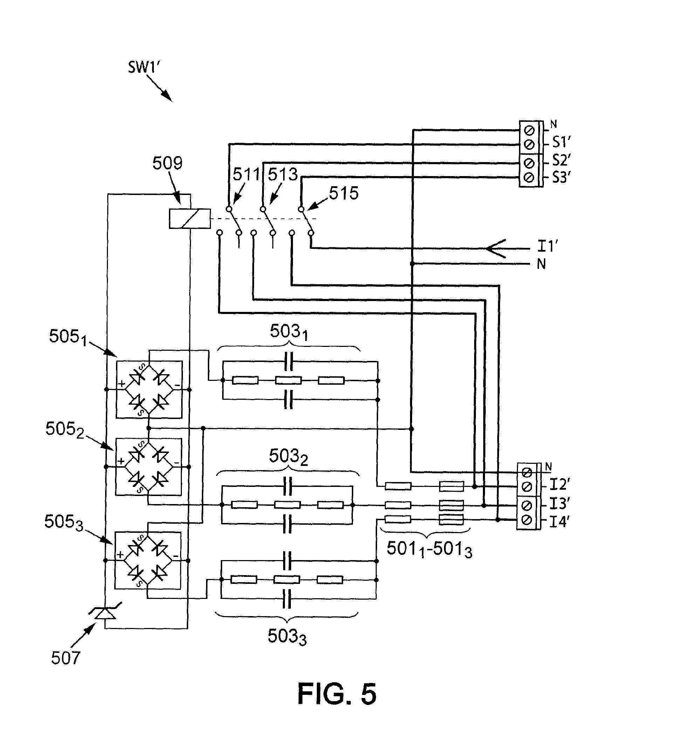

Comme vu ci-avant, le sous-module SW1' est apte à détecter la tension présente sur ses entrées pour décider du basculement entre un état de fonctionnement normal et un état de non-alimentation par le réseau. La **figure 5** décrit un exemple de réalisation du premier sous-module de commutation SW1' selon le deuxième mode de réalisation illustré à la figure 3, permettant ainsi de mieux comprendre son fonctionnement.

Sur cette figure 5, le mécanisme permettant de détecter la présence, ou non, de courant sur l'une des phases du réseau triphasé est explicité en détail. En effet, en plus des connexions permettant de relier les entrées I1'-I4' aux sorties S1'-S3', déjà illustrées sur la figure 3, le sous-module SW1' présentent des éléments 501 à 509 permettant de gérer la commutation de ce sous-module.

En particulier, chacune des entrées I2',I3',I4' est connectée tout d'abord optionnellement à un premier élément 501₁-501₃, comprenant une ou plusieurs résistances dont la fonction est de baisser la tension provenant de ces entrées, afin de sécuriser la manipulation par un opérateur. Des éléments 503i comprenant une ou plusieurs résistances, ainsi qu'un ou plusieurs condensateurs, sont ensuite utilisés et respectivement connectés à des ponts de diodes 505i dont la fonction est de redresser le courant afin d'obtenir un courant continu.

Ces éléments 505i sont connectés à une diode Zener 507 qui va servir à réguler la tension d'alimentation d'un relais 509, qui lui-même contrôle le basculement simultané de trois commutateurs 511,513,515 dans l'une ou l'autre des positions possibles.

Ce basculement se fait en fonction d'une valeur seuil Vs de tension prédéfini. Si la tension détectée par le relais 509 est supérieure ou égale à cette valeur seuil Vs, cela indique qu'au moins une des entrées I2' à I4' est alimentée en courant, et donc le relais 509 va basculer les commutateurs 511,513,515 dans une première position correspondant à l'état B de fonctionnement normal illustré à la figure 4A, afin de connecter les entrées I2' à I4' aux sorties S1' à S3'. Le compteur électrique triphasé COMPT' sera alors connecté aux sorties S1' à S3' et sera ainsi alimenté par le réseau électrique triphasé.

A l'inverse, si la tension détectée par le relais 509 est inférieure à cette valeur seuil Vs, cela signifie qu'aucune entrée I2' à I4' n'est alimentée en courant. Le relais 509 va alors basculer les commutateurs 511,513,515 dans une deuxième position correspondant à l'état A d'alimentation locale illustré à la figure 4C, afin de connecter l'entrée I1' à la sortie S3'. Le compteur électrique sera alors alimenté localement par les moyens d'alimentation PWR.

La valeur de tension de seuil Vs est choisie en fonction des tensions habituellement utilisées aux entrées I2' à I4'. Dans le cas d'un équipement triphasé, des tensions allant de 57 Volts à 250 V sont usuelles, auquel cas une valeur seuil VS de l'ordre de 12 Volts permet de bien distinguer si une tension est fournie ou non par le réseau électrique.

La remise sous tension inopinée d'une installation comprenant un compteur haute tension, par exemple, n'a aucune conséquence au niveau de la sécurité électrique, ni du point de vue de l'opération de télé-relevé en cours qui continue normalement sans coupure de transmission, du fait de la conception même de l'alimentation interne du compteur, comprenant notamment des condensateurs.

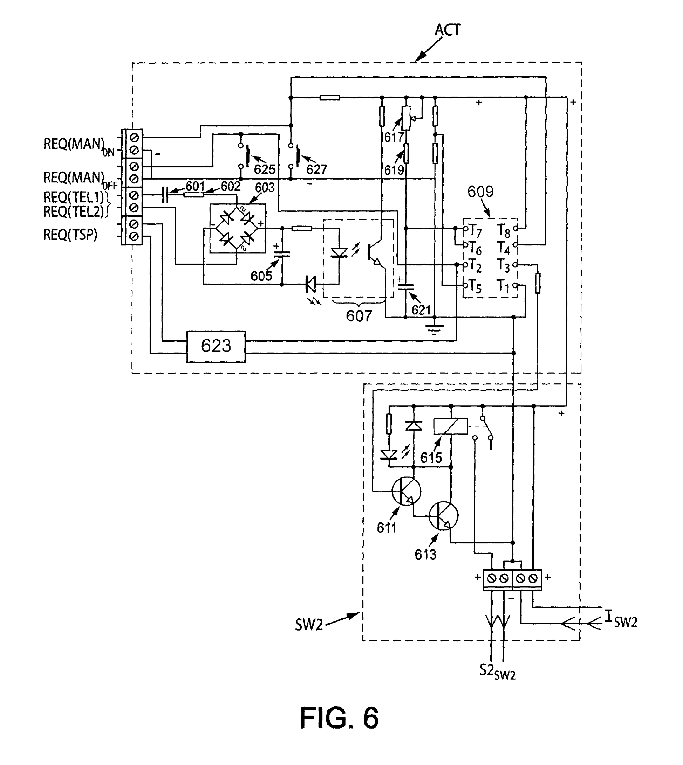

La **figure 6** illustre un exemple de réalisation des moyens d'activation ACT et du sous-module de commutation SW2, utilisable aussi bien dans le module de commutation SW du premier mode de réalisation de la figure 1 que dans le module de commutation SW' du deuxième mode de réalisation de la figure 3.

Dans la figure 6, un appel de télé-relève par le réseau téléphonique filaire REQ(TEL1), ou par un réseau sans-fil REQ(TEL2), va être reçu par le bornier de gauche. En période normale la tension présente sur les bornes connectées à la ligne téléphonique est de l'ordre de 40 Volts à 48 Volts, voire même 54 Volts, suivant qu'elle provient d'une ligne téléphonique plus ou moins éloignée du central téléphonique. Un appel de télé-relève se traduit par l'apparition d'un train d'impulsions (le train des sonneries) sous la forme d'une tension alternative de l'ordre de 80 Volts superposée à la composante continue (48 Volts) de la ligne téléphonique.

Le condensateur non polarisé 601 bloque la composante continue de la ligne téléphonique, mais laisse transiter, en l'atténuant, la tension alternative de sonnerie. Cette tension alternative atténuée est à nouveau atténuée par la résistance 602, puis est redressée par le pont de diodes 603 et filtrée par le condensateur 605 et peut donc attaquer l'entrée du photo-coupleur 607, qui assure une fonction d'isolation galvanique. Ce phototransistor interne, par exemple de type 4N25 ou 4N27, devient passant dès la première impulsion (c'est-à-dire la première sonnerie) amenant au potentiel négatif la borne T2, dite de « Déclenchement » du temporisateur 609 (par exemple de type NE 555), qui peut consister en un circuit intégré monostable non re-déclenchable.

La borne de sortie T3 du temporisateur 609 est alors activée et, via les transistors 611 et 613, enclenche le relais 615 qui, par un contact, réalise l'alimentation, par exemple en 12 Volts du compteur connecté à la sortie S2_{SW2} grâce à l'alimentation 12 Volts venant du régulateur par l'entrée I_{SW2}. Cette alimentation est maintenue pendant un période de temps prédéfinie, par exemple environ 15 minutes. Cette temporisation peut être définie sans grande précision par le potentiomètre 617, monté en rhéostat, la résistance 619 et le condensateur chimique polarisé 621, connecté aux bornes T6, dite de «Seuil», et T7, dite «Vref» du temporisateur 609.

Au bout de la quatrième ou cinquième sonnerie, le compteur COMPT désormais alimenté est complètement initialisé et sa carte modem prend la ligne téléphonique afin de renvoyer le télé-relevé au serveur central de télé-relève, avec une consommation en courant continu supérieure ou égale à environ 25 à 35mA. Le serveur central téléphonique à l'origine de l'appel de télé-relève détecte cette consommation en courant continu, interrompt les trains de sonnerie de 80 Volts alternatifs, et la communication de télé-relève s'effectue.

La commutation du relais 615 peut aussi être effectuée grâce à un module de détection de porteuse 623, permettant de détecter une requête en réalimentation magnétique REQ(TSP) utilisant typiquement une porteuse 50 kHz. Ce module 623 est connecté à la borne T2 du temporisateur 609 afin de lancer la temporisation de manière similaire à ce qui a été dit précédemment.

La commutation du relais 615 peut enfin aussi être effectuée grâce à des boutons poussoirs 625 et 627, aptes à recevoir respectivement une requête REQ(MAN)_{ON} en lancement de réalimentation et une requête REQ(MAN)_{OFF} en arrêt de réalimentation, et connectés respectivement aux bornes T2 et T4 du temporisateur 609 afin de permettre le lancement, de manière similaire à ce qui a été dit précédemment, ou l'interruption de la temporisation.

Habituellement, dans le cas d'une requête à distance par téléphonie, le central comporte un logiciel gérant la télé-relève et présentant un délai d'attente TOᵢ (pour « time-out ») pendant lequel il sera opératif. De son côté, le compteur peut présenter un temps d'initialisation t_{INIT}, typiquement de l'ordre de la dizaine de secondes. Si le temps d'initialisation du compteur est trop long, il se peut que celui-ci termine son initialisation alors que le délai d'attente du logiciel de télé-relève a expiré. Dans un tel cas, la télé-relève échoue.

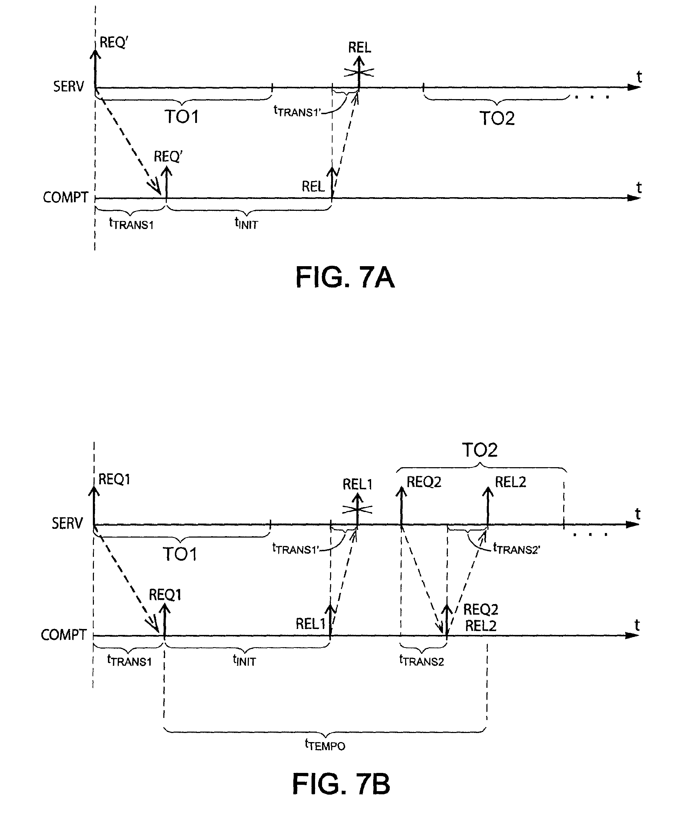

Ce cas est illustré par le chronogramme de la **figure 7A****.** Sur ce chronogramme, lorsque le logiciel du serveur de télémesure SERV lance une requête de télé-relevé, un délai d'attente TO1 du logiciel est initié. La requête arrive au dispositif de gestion après un temps de transmission t_{TRANS1}. Ce temps peut être particulièrement long dans le cas d'une transmission sur réseau sans fil, du fait des délais supplémentaires inhérents aux réseaux de type GSM par exemple. La réception de la requête REQ' entraîne le redémarrage du compteur qui nécessite un temps t_{INIT} d'initialisation. Ce n'est qu'à l'issue de ce temps d'initialisation que le télé-relevé REL s'effectue et est transmis au serveur distant. Celui reçoit le télé-relevé REL après un délai supplémentaire t_{TRANS1}', dépendant encore une fois du type de liaison de communication.

Si le délai d'attente TO1 du logiciel est trop court, le télé-relevé REL atteint le serveur alors que le logiciel n'est plus actif, et la télémesure échoue. Certains logiciels présentent une fonction de rappel automatique, dans lequel la requête en télémesure est relancée automatiquement plusieurs fois, ce qui est représenté par le délai d'attente TO2 sur la figure 7A. Cependant, la probabilité que le télé-relevé REL atteigne le serveur entre deux délais d'attente, et donc échoue, existe bel et bien.

La temporisation générée par l'élément 609 est alors particulièrement utile, en particulier si la requête est effectuée par téléphonie sans fil, comme illustré à **la** **figure 7B****.** En effet, le premier appel de télé-relève REQ1 déclenche la temporisation de l'alimentation locale du compteur pendant une période prédéfinie t_{TEMPO}. Le compteur va alors être alimenté localement par les moyens PWR durant cette période et s'initialise d'abord pendant la période t_{INIT}.

Si le délai d'attente du logiciel TO1 est trop court, la télémesure va échouer de façon similaire à la figure 7A, le premier télé-relevé REL1 arrivant après la fin du délai TO1. Cependant, dans le cas d'un logiciel effectuant un rappel automatique, le logiciel va lancer une deuxième requête REQ2 qui sera reçue par le compteur après un délai de transmission t_{TRANS2}. Cette fois-ci, à la différence du cas de la figure 7A, le compteur est déjà initialisé et alimenté. Il va donc effectuer le télé-relevé REL2 et retransmettre celui-ci immédiatement. Ce télé-relevé REL2 sera reçu par le serveur rapidement, après un délai de transmission t_{TRANS2}', dans le délai d'attente TO2 où le logiciel est toujours actif, et la télémesure aura alors réussi.

Un délai de temporisation de 15 minutes a été indiqué ci-dessus, à titre purement illustratif. Cependant, ce délai de temporisation est réglable, et peut être par exemple augmenté si nécessaire, en fonction du besoin en temporisation et pour adapter le fonctionnement du système à des logiciels qui pourraient ne pas relancer immédiatement un rappel automatique.

Bien entendu, l'invention n'est pas limitée aux exemples de réalisation ci-dessus décrits et représentés, à partir desquels on pourra prévoir d'autres modes et d'autres formes de réalisation, sans pour autant sortir du cadre de l'invention.

Par exemple, dans les figures 1 et 3, les moyens d'alimentation PWR, d'activation ACT et le module de commutation SW sont représentés comme des entités fonctionnellement séparées, à titre purement illustratif. Il est bien évident que les différents éléments de ces différents modules peuvent être rassemblés ou organisés sous une forme différente, du moment que les fonctions réalisées par ces éléments sont conservées.

De plus, le module de commutation SW est présenté comme comprenant deux sous-modules de commutation successifs SW1 et SW2, arrangés dans un ordre précis. Il est envisageable d'implémenter le module SW en inversant l'ordre de ces sous-modules, voire en utilisant un seul sous-module de commutation permettant à la fois de contrôler la tension provenant du réseau électrique et de basculer sur l'alimentation locale sur réception d'une requête en réalimentation.

## Revendications

1. Dispositif de gestion d'alimentation (1) d'un compteur électrique comprenant des moyens d'alimentation électrique (PWR) et un module de commutation (SW) comportant une première entrée (I1) connectée aux moyens d'alimentation électrique, au moins une deuxième entrée (I2) apte à être connectée à une source d'électricité (ELEC) externe au dispositif de gestion d'alimentation et au moins une sortie (S) apte à être connectée au compteur électrique (COMPT), ledit module de commutation (SW) étant apte à connecter la première entrée (I1) avec la sortie (S) dans un premier état de fonctionnement (A) après réception d'une requête en réalimentation par le dispositif de gestion d'alimentation.

2. Dispositif de gestion d'alimentation selon la revendication 1, dans lequel le module de commutation (SW) est apte à connecter la au moins deuxième entrée (I2) avec la au moins une sortie (S) dans un deuxième état de fonctionnement (B), **caractérisé en ce que** le module de commutation bascule dans le premier état de fonctionnement (A) si la tension d'entrée (V) de la au moins deuxième entrée est inférieure à une valeur de tension seuil (Vs) et **en ce que** le module de commutation bascule dans le deuxième état de fonctionnement (B) si la tension d'entrée de la au moins deuxième entrée (V) est supérieure ou égale à une valeur de tension seuil (Vs).

3. Dispositif de gestion d'alimentation selon la revendication 2, dans lequel le module de commutation (SW) comprend un premier sous-module de commutation (SW1) présentant une première entrée (I1_{SW1}), au moins une deuxième entrée (I2_{SW1}) connectée à la au moins une deuxième entrée (I2) du module de commutation, et au moins une sortie (S_{SW1}) connectée à la au moins une deuxième sortie (S) du module de commutation, le moyen de commutation (SW) comprenant en outre un deuxième sous-module de commutation (SW2) présentant une entrée (I_{SW2}), connectée à l'entrée (I1) du module de commutation, et une sortie (S2_{SW2}), connectée à la première entrée (I_{SW1}) du premier sous-module de commutation (SW1), **caractérisé en ce que** le premier-module de commutation (SW1) connecte sa sortie (S_{SW1}) avec sa première entrée (I1_{SW1}) si la tension d'entrée (V) de sa au moins deuxième entrée (I2_{SW1}) est inférieure à la valeur de tension seuil (Vs), le premier-module de commutation (SW1) connecte sa sortie (S_{SW1}) avec sa au moins deuxième entrée (I2_{SW1}) si la tension d'entrée (V) de sa au moins deuxième entrée (I2_{SW1}) est supérieure ou égale à la valeur de tension seuil (Vs), et le deuxième sous-module de commutation (SW2) connecte son entrée (I_{SW2}) avec sa sortie (S2_{SW2}) après réception d'une requête en réalimentation (REQ).

4. Dispositif de gestion d'alimentation selon l'une des revendications précédentes, **caractérisé en ce qu'**il comprend en outre des moyens d'activation (ACT) connectés au module de commutation, aptes à recevoir une requête en réalimentation et à déclencher le basculement dudit module de commutation dans son premier état de fonctionnement (A) en réponse à ladite requête en réal imentation.

5. Dispositif de gestion d'alimentation selon la revendication 4, **caractérisé en ce que** les moyens d'activation comportent au moins un module d'activation téléphonique (TEL1,TEL2) apte à recevoir la requête en réalimentation sous forme téléphonique (REQ(TEL1),REQ(TEL2)).

6. Dispositif de gestion d'alimentation selon la revendication 5, **caractérisé en ce que** le module d'activation téléphonique comporte un module d'activation téléphonique sans fil (TEL2) apte à recevoir la requête en réalimentation sous forme téléphonique par voie hertzienne(REQ(TEL2)).

7. Dispositif de gestion d'alimentation selon la revendication 6, **caractérisé en ce qu'**il comprend un module d'horloge (CLK) connecté au module d'activation téléphonique sans fil (TEL2) et apte à activer ledit module d'activation téléphonique sans fil durant au moins une période de temps et à désactiver lesdits moyens d'activation en dehors de ladite au moins une période de temps.

8. Dispositif de gestion d'alimentation selon la revendication 7, dans lequel ledit module d'horloge (CLK) est en outre connecté aux moyens d'alimentation électrique (PWR), **caractérisé en ce que** ledit module d'horloge est apte à connecter le module d'activation téléphonique sans fil (TEL2) aux moyens d'alimentation électrique durant ladite au moins une période de temps, et à isoler le module d'activation téléphonique sans fil des moyens d'alimentation électrique en dehors de ladite au moins une période de temps.

9. Dispositif de gestion d'alimentation selon l'une des revendications 4 à 8, **caractérisé en ce que** les moyens d'activation (ACT) comportent un module d'activation magnétique (TSP) apte à recevoir la requête en réalimentation sous forme d'un signal magnétique (REQ(TSP)).

10. Dispositif de gestion d'alimentation selon l'une des revendications 4 à 9, **caractérisé en ce que** les moyens d'activation (ACT) comportent un module d'activation manuelle (MAN) apte à recevoir la requête en réalimentation sous forme d'un signal manuel (REQ(MAN)).

11. Dispositif de gestion d'alimentation selon l'une des revendications 4 à 10, **caractérisé en ce que** le moyens d'activation (ACT) comportent un module de temporisation (609) apte à déclencher le basculement du module de commutation (SW) dans son premier état de fonctionnement (A) pendant une durée prédéterminée (t_{TEMPO}) après réception de la requête en réalimentation.

12. Dispositif de gestion d'alimentation selon l'une des revendications précédentes, **caractérisé en ce que** les moyens d'alimentation (PWR) comportent un module de conversion photoélectrique (PV) apte à convertir de l'énergie lumineuse en énergie électrique fournie au moins partiellement à la première entrée (I1) du module de commutation (SW).

13. Dispositif de gestion d'alimentation selon l'une des revendications précédentes, **caractérisé en ce que** les moyens d'alimentation (PWR) comportent un module de stockage électrique (BAT) apte à stocker de l'énergie électrique destinée à être fournie au moins partiellement à la première entrée (I1) du module de commutation (SW).

14. Dispositif de gestion d'alimentation selon l'une des revendications précédentes, dans lequel le module de commutation (SW) comporte une deuxième entrée (I2'), une troisième entrée (I3') et une quatrième entrée (I4') aptes à recevoir respectivement un premier signal de phase (PH1), un deuxième signal de phase (PH2), un troisième signal de phase (PH3) provenant d'une source d'électricité triphasée, et dans lequel le module de commutation (SW) comporte une première sortie (S1'), une deuxième sortie (S2') et une troisième sortie (S3') aptes à être connectées respectivement à la première entrée de phase, la deuxième entrée de phase et la troisième entrée de phase d'un compteur électrique triphasé (COMPT'), **caractérisé en ce que**, dans ledit premier état de fonctionnement (A), la première entrée (I1') du module de commutation (SW) est connectée à la première sortie (S1') du module de commutation, et **en ce que**, dans un deuxième état de fonctionnement (B), les deuxième, troisième et quatrième entrées du module de commutation (I2',I3',I4') sont connectées respectivement aux première, deuxième et troisième sorties (S1',S2',S3') du module de commutation (SW).

15. Système de mesure électrique comprenant un compteur électrique comportant au moins une entrée apte à recevoir un signal électrique, et un dispositif de gestion d'alimentation selon l'une des revendications précédentes, la au moins une sortie du module de commutation du dispositif de gestion d'alimentation étant connectée à la au moins une entrée du compteur électrique.

## Revendications modifiées

### Revendications modifiées conformément à la règle 137(2) CBE.

**1.** Dispositif de gestion d'alimentation (1) d'un compteur électrique comprenant des moyens d'alimentation électrique (PWR) et un module de commutation (SW) comportant une première entrée (I1) connectée aux moyens d'alimentation électrique, au moins une deuxième entrée (12) apte à être connectée à une source d'électricité (ELEC) externe au dispositif de gestion d'alimentation et au moins une sortie (S) apte à être connectée au compteur électrique (COMPT), ledit module de commutation (SW) étant apte à connecter la première entrée (I1) avec la sortie (S) dans un premier état de fonctionnement (A) après réception d'une requête en réalimentation par le dispositif de gestion d'alimentation.

**2.** Dispositif de gestion d'alimentation selon la revendication 1, dans lequel le module de commutation (SW) est apte à connecter ladite au moins une deuxième entrée (12) avec ladite au moins une sortie (S) dans un deuxième état de fonctionnement (B), **caractérisé en ce que** le module de commutation bascule dans le premier état de fonctionnement (A) si la tension d'entrée (V) de la au moins deuxième entrée est inférieure à une valeur de tension seuil (Vs) et **en ce que** le module de commutation bascule dans le deuxième état de fonctionnement (B) si la tension d'entrée de ladite au moins deuxième entrée (V) est supérieure ou égale à une valeur de tension seuil (Vs).

**3.** Dispositif de gestion d'alimentation selon la revendication 2, dans lequel le module de commutation (SW) comprend un premier sous-module de commutation (SW1) présentant une première entrée (I1_{SW1}), au moins une deuxième entrée (I2_{SW1}) connectée à ladite au moins une deuxième entrée (I2) du module de commutation, et au moins une sortie (S_{SW1}) connectée à ladite au moins une deuxième sortie (S) du module de commutation, le moyen de commutation (SW) comprenant en outre un deuxième sous-module de
